(19) Europäisches Patentamt

European Patent Office

Office européen des brevets

(11) **EP 4 246 169 A1**

(12) **EUROPEAN PATENT APPLICATION**

(43) Date of publication:
20.09.2023 Bulletin 2023/38

(21) Application number: 22161898.6

(22) Date of filing: 14.03.2022

(51) International Patent Classification (IPC):
*G01R 33/56* (2006.01)      *G01R 33/563* (2006.01)

(52) Cooperative Patent Classification (CPC):
G01R 33/56341; G01R 33/5608

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Healthcare GmbH**
**91052 Erlangen (DE)**

(72) Inventors:
• **Pierre, Eric**
**Essendon, 3040 (AU)**
• **Staeb, Daniel**
**Port Melbourne, VIC 3207 (AU)**
• **Feiweier, Thorsten**
**91099 Poxdorf (DE)**
• **O'Brien, Kieran**
**West End, 4101 (AU)**

(54) **AUGMENTING DIFFUSION-WEIGHTED MAGNETIC RESONANCE IMAGING DATA USING A TRAINED ARTIFICIAL NEURAL NETWORK**

(57) According to a computer-implemented method for augmenting DWI-data, which contains, for each of a plurality of Q-space points (16), respective MR-datasets for a target voxel and for a plurality of auxiliary voxels in a predefined neighborhood of the target voxel, a trained artificial neural network (8) is applied to input data, which contains the respective MR-datasets of the target voxel and the plurality of auxiliary voxels for all of the plurality of Q-space points (16). An interpolated MR-dataset for the target voxel and for a target Q-space point (17), which is not contained in the plurality of Q-space points (16), is computed by means of the artificial neural network (8) depending on the input data.

FIG 1

**Description**

The invention is directed to a computer-implemented method for augmenting diffusion-weighted magnetic resonance imaging, DWI-, data, wherein the DWI-data contains, for each of a plurality of Q-space points, respective magnetic resonance, MR-, datasets for a target voxel and for a plurality of auxiliary voxels in a predefined neighborhood of the target voxel. The invention is further directed to a computer-implemented training method for training an artificial neural network for augmenting DWI-data, to a method for DWI-imaging, to a data processing apparatus, to a magnetic resonance imaging system for DWI and to a computer program product.

Magnetic resonance, MR, imaging systems use a strong external magnetic field to align nuclear spins of an object under examination and excite them to precess about the corresponding alignment by means of applying an excitation RF pulse. The precession or the transition of the spins from this excited state to a state with lower energy, respectively, generates an alternating electromagnetic field in response, which can be detected via receiving antennas as an MR signal.

With the aid of magnetic gradient fields, a position encoding can be impressed on the signals, which subsequently allows the received signal to be assigned to a volume element of the object under investigation. The received signal can then be analyzed, for example to provide an image representation of the object under examination.

Diffusion-weighted MR-imaging, denoted as DWI in the following, exploits the diffusion of water molecules in the object, in particular in tissue of a human or animal, due to Brownian motion. Different types of materials or tissues exhibit different respective diffusion coefficients. Therefore, imaging a measure for the spatial variation of diffusion is particularly useful for tissue characterization.

DWI, however, is an inherently slow acquisition method and DWI-acquisitions may take a relatively long time. For fibre-tracking and fixel-based analyses, for example, which are valuable tools in the study and diagnosis of neurological disorders, many diffusion-weighted images according to a large number of diffusion gradient directions and strengths, for example 60 directions and multiple b-values, may be required. Therein, fixel-based analyses can be understood defined as analyses of parameters related to individual fibre populations within each voxel, wherein voxels are denoted as fixels in this context. Even with known acceleration techniques, such as simultaneous multi-slice imaging, acquisition times can be on the order of ten minutes or more. As a consequence, spatial resolution and/or the Q-space resolution, as well as patient comfort may be reduced and problems due to patient motions become more severe.

The publication Q.Tian et al.: "DeepDTI: High-fidelity six-direction diffusion tensor imaging using deep learning", Neuroimage 219, 117017 (2020) describes the use of deep convolutional neural networks to improve the spatial resolution of DWI images. To this end, low quality input images for a b-value of b=0 and for six fixed DWI-directions with non-zero b-value are used together with an anatomical T1/T2-weighted image as an input to a deep convolutional neural network. The network is trained to produce high quality DWI-images with an improved spatial resolution again for b=0 and the same six DWI-directions contained in the input data.

It is an objective of the present invention to achieve a further acceleration for DWI, in particular for acquisition protocols or applications of DWI, which require a large number of gradient directions and/or b-values.

This objective is achieved by the respective subject matter of the independent claims. Further implementations and preferred embodiments are subject matter of the dependent claims.

The invention is based on the idea to acquire DWI-data for a plurality of Q-space points for a single target voxel and a plurality of neighboring or auxiliary voxels and to augment the acquired DWI-data by respective MR-data for one or more further Q-space points. To this end, the available MR-datasets for the target voxel and the plurality of neighboring or auxiliary voxels are used as an input for a trained artificial neural network, which delivers an interpolated MR-dataset for the target voxel and the one or more further Q-space points, wherein the interpolated MR-dataset is, in particular, an MR-dataset interpolated in Q-space or, more specifically for example an MR-dataset interpolated in Q-space and position space.

According to an aspect of the invention, a computer-implemented method for augmenting diffusion-weighted magnetic resonance imaging data is provided. Here and in the following, DWI is used as an abbreviation for diffusion-weighted magnetic resonance imaging, while MR is used as an abbreviation for magnetic resonance. According to the computer-implemented method, the DWI-data is provided and contains, for each of a plurality of Q-space points, which contains, in particular, three or more Q-space points, respective MR-datasets for a target voxel and for a plurality of auxiliary voxels in a predefined neighborhood of the target voxel. A trained artificial neural network, is applied to input data, which contains the respective MR-datasets of the target voxel and the plurality of auxiliary voxels for all of the plurality of Q-space points. An interpolated MR-dataset for the target voxel and for a target Q-space point, which is not contained in the plurality of Q-space points, is computed by means of the artificial neural network depending on the input data.

Unless stated otherwise, all steps of the computer-implemented method may be performed by at least one computing unit, which may also be denoted as a data processing apparatus, for example of a magnetic resonance imaging system. In particular, the data processing apparatus comprises at least one processing circuit, which is configured or adapted to perform a computer-implemented method according to the invention may perform the steps of the computer-implemented method. For this purpose, the data processing apparatus may in particular store a computer program comprising instructions, which, when executed by the data processing device, in particular the at least one processing circuit, cause the data processing apparatus to execute the computer-implemented method.

In DWI, at least one magnetic field gradient pulse, also denoted as diffusion gradient lobe, is applied for example symmetrically on either side of an RF pulse, for example an 180°-pulse wherein RF stands for radio frequency. In this way, stationary molecules, for example water molecules may be distinguished from moving water molecules. While stationary water molecules acquire the same phase information by the diffusion gradient lobes prior to and after the RF pulse, moving water molecules obtain slightly different phases prior to and after the RF pulse. Therefore, the further the move between the diffusion gradient lobes, the more the moving water molecules dephase. Therefore, the further they move, the less MR-signal they cause.

DWI uses, in general, different amounts of diffusion-weighting in different acquisition time frames. The amount of the diffusion-weighting may be given by the so- called b-value, which may, for example, be defined as

$$b = \gamma^2 * G^2 * \delta^2 * (\Delta - \delta/3).$$

Therein, $\gamma$ represents the gyromagnetic ratio, G denotes the amplitude of the diffusion gradient lobes, $\delta$ denotes the duration of the diffusion gradient lobes and $\Delta$ denotes the duration between the pair of diffusion gradient lobes. Therein, it may for example be assumed that the diffusion gradient lobes have an approximately rectangular shape and both have the same amplitude G and duration $\delta$.

Furthermore, DWI also uses, in general, different directions of the diffusion gradient lobes in position space to acquire directional information regarding the diffusion properties.

In DWI, the concept of Q-space is well established. Therein, the Q-space is a three-dimensional space, wherein each point in the Q-space uniquely defines a three-dimensional direction of the magnetic field gradient for the diffusion gradient lobes and a b-value. For example, the b-value may correspond to the radial distance of the corresponding point from the center of the Q-space. Consequently, images with b = 0 correspond to a Q-space point in the center of the Q-space, while acquisitions with a non-zero but constant b-value in different gradient directions lie on a certain sphere in the Q-space, which may also be denoted as Q-space shell. For example, the following relation between a Q-space point Q(t) and the diffusion encoding gradient G(t) may hold:

$$Q(t) = \gamma \int_0^t G(t') \, dt'$$

It is noted that direction of the diffusion gradients in position space may correspond one-to-one to directions in Q-space. However, this is not necessarily the case. In other words, there may be transformations involved, in particular rotational transformations, when mapping a direction in positional space into the Q-space. This may have practical reasons, for example since the physical axes in the position space, which are defined by the gradient coils of the MRI system and are usually denoted by X, Y and Z, do not necessarily correspond to the logical axes for MR-imaging, namely phase-encoding direction, read-out direction and slice direction, or a patient coordinate system defined by anatomic directions, for example sagittal, coronal and transversal. However, in any case there is a unique correspondence between a direction of the magnetic field gradient in combination with the b-value and a corresponding point in Q-space.

The MR-datasets for plurality of Q-space points for the target voxel and for the plurality of auxiliary voxels may for example be obtained by means of conventional DWI. In some implementations, this may include pre-processing steps such as, but not limited to, bias-field removal, motion correction, Gibbs-ringing removal and/or diffusion gradient error correction. It is noted, however, that the plurality of Q-space points, which is used for the input data for the artificial neural network, does not necessarily contain all available data for all measured or acquired Q-space points. In particular, the plurality of Q-space points may be a subset of all available measured Q-space points. The subset may be selected according to the desired accuracy for the prediction and/or depending on the position of the target Q-space point, et cetera. In general, however, no MR-datasets are available for the target Q-space point at least for the target voxel or such MR-data may be available but be not sufficient or may not be suitable for another reason.

The artificial neural network is designed, in particular designed and trained, to interpolate the input data at the desired position in position space, namely the target voxel, and the desired point in Q-space, namely the target Q-space point.

In other words, the interpolated MR-dataset is, in particular, an MR-dataset interpolated in Q-space or, more specifically for example an MR-dataset interpolated in Q-space and position space.

When the artificial neural network is applied to the input data, it carries out an interpolation in Q-space, in particular in Q-space and position space. In particular, the interpolation in Q-space takes into account all available data in Q-space, namely at the plurality of Q-space points, and in position space, namely at the target voxel itself and the auxiliary voxels. In this way the underlying diffusion processes may be captured in a particularly exact way.

A particular advantage of using a trained artificial neural network for the interpolation is that the artificial neural network is predestined for reflecting the highly non-linear underlying diffusion processes in DWI. By training the artificial neural network accordingly, it inherently adopts the non-linear physical mechanisms. In other words, at least the interpolation in Q-space is a non-linear interpolation. Therefore, the artificial neural network may yield significantly more accurate results than for example linear-interpolation approaches could and, in addition, is highly efficient from a computational point of view, as opposed to possible other non-linear approaches.

In particular, the DWI-data, in other words the MR-datasets, may be given by respective MR-images or MR-data for MR-images for two or more slices, in general for a plurality of slices. Each MR-image corresponds to a two-dimensional sectional image perpendicular to a predefined slice direction and the different slices correspond to different sections along the slice direction. Each MR-image comprises a plurality of two-dimensional pixels.

In general, the term voxel stands for volumetric pixel or, in other words to a pixel of a certain thickness in the third dimension. In the context of MR-imaging, a single slice necessarily has a finite thickness. Thus, the expression voxel is commonly used to indicate a cuboid volume element in a single slice or a single pixel in a two-dimensional MR-image of a single slice.

The neighborhood of the target voxel may be understood as a three-dimensional neighborhood of the target voxel. For example, the neighborhood of the target voxel may comprise nearest-neighbor voxels in the same slice as the target voxel and corresponding nearest-neighbor voxels in the nearest-neighbor slices of the target voxels. However, the neighborhood may also be predefined in a different manner. For example, also second-nearest neighbor voxels, also denoted as next-nearest neighbor voxels, and/or third-nearest neighbors may be considered. In particular, the predefined neighborhood of the target voxel comprises all of the auxiliary voxels or, in other words, all of the auxiliary voxels represent the predefined neighborhood of the target voxel. In particular, the choice of the neighborhood may be considered as a tradeoff between computational time and complexity of the artificial neural network on the one hand and accuracy of the interpolated MR-dataset on the other hand.

The predefined neighborhood may, in some implementations, correspond to a symmetric neighborhood in three dimensions of the target voxel comprising 26 auxiliary voxels surrounding the target voxel. In other words, the auxiliary voxels in combination with the target voxel form a cube with a side length of three voxels, wherein the target voxel is located in the center of the cube.

When the artificial neural network is applied to the input data, it generates an output. The interpolated MR-dataset may directly be given by the output or may be derived from the output. In this way it can be understood that the interpolated MR-dataset for the target voxel and for the target Q-space point is computed by means of the artificial neural network depending on the input data.

Computing the interpolated MR-data for the target voxel and the target Q-space point may be understood as augmenting the DWI-data, in particular augmenting the DWI-data by the interpolated MR-dataset.

In other words, the DWI-data represent the result of an undersampled Q-space acquisition and the undersampling is at least in part compensated by augmenting the DWI-data according to the invention. Therein, undersampling can be understood such that it refers to a degree of sampling the Q-space, which is less than a predefined target sampling or coverage. For example, if a certain application requires N different Q-space points but the DWI-data comprises information only for a fraction of the N Q-space points, the computer-implemented method according to the invention may be used to obtain the missing information for the non-sampled Q-space points in terms of the interpolated MR-data for the target voxel and, if applicable, for further target voxels.

In this way, the acquisition time for acquiring the DWI-data may be significantly reduced without the disadvantage of a potential loss of information for the non-sampled Q-space points.

In particular, the DWI-data may comprise data for further voxels outside of the predefined neighborhood of the target voxel, which are not part of the auxiliary voxels.

According to several implementations, the input data comprises only the data for the target voxel and the auxiliary voxels but no data for additional voxels. In other words, the artificial neural network is designed to be applied to the available DWI-data in a voxel-by-voxel manner. This means that in a single prediction step, only the interpolated MR-dataset for the target voxel is computed but not for one or more further target voxels.

The interpolated MR-datasets for the one or more further target voxels may be computed in respective further steps by applying the artificial neural network accordingly to further input data. However, also a parallel application of different instances of the artificial neural network or different artificial neural networks to different target voxels is possible.

The voxel-by-voxel approach has the advantage that the complexity of the artificial neural network, for example the size of the artificial neural network, may be particularly low, since the artificial neural network only has to predict the interpolated MR-datasets for a single target voxel. To this end, the artificial neural network uses the information available for the target voxel and the auxiliary voxels for the plurality of Q-space points in order to interpolate them for the target Q-space point.

Due to the voxel-by-voxel approach, also the computational time required for interpolating the MR-dataset for the target voxel and the target Q-space point is low. In consequence, an overall acceleration factor is increased or the time required to obtain the augmented DWI-data is particularly short.

In alternative implementations, the same artificial neural network, in particular a single instance of the artificial neural network, may be used to generate respective interpolated MR-datasets for the target voxel and for one or more further target voxels, in particular for a whole neighborhood of target voxels, at once.

According to several implementations, the neighborhood of the target voxel is defined such that the auxiliary voxels in combination with the target voxel form a cube with a side length of three voxels, wherein the target voxel is located in the center of the cube.

Limiting the neighborhood in this way has the advantage of a significantly reduced size of the input data and therefore a significantly reduced complexity, which may be used for designing the artificial neural network, in particular the artificial neural network. Consequently, also memory and runtime requirement for computing the interpolated MR-dataset may be significantly reduced or limited. It has been found in simulations that such a neighborhood is still sufficient to achieve a high quality and accuracy of the interpolated MR-dataset for many applications.

According to several implementations, one of the plurality of Q-space points corresponds to a Q-space center.

In other words, the b-value is equal to zero for this one of the plurality of Q-space points. This means that for acquiring the DWI-data, the Q-space center has been acquired in such implementations. It has been found that the Q-space center, where actually no diffusion gradient is applied, or in other words a diffusion gradient of zero strength is applied, is a valuable reference dataset, which leads to a high accuracy of the interpolated MR-dataset.

According to several implementations, all Q-space points of the plurality of Q-space points, which are not located in the Q-space center, are arranged on a single Q-space shell.

In other words, the plurality of Q-space points consists of Q-space points, which all have the same b-value or distance from the Q-space center and, optionally, the Q-space center itself.

It has been found that the artificial neural network has a particularly high performance in such implementations.

It is noted, however, that the computer-implemented method may then be carried out multiple times for different Q-space shells or different b-values, respectively, if this is desired or required for a specific application. In other words, the artificial neural network may for example be trained for a specific b-value, which makes it more performant, more accurate and less complex.

In particular, in implementations where all of the Q-space points of the plurality of Q-space points except for the Q-space center are located on the single Q-space shell, also the target Q-space point is located on the same Q-space shell.

According to several implementations, the plurality of Q-space points comprises at least two subsets of Q-space points, wherein for each subset of Q-space points, all Q-space points of the respective subset are arranged on a respective single Q-space shell.

In other words, the input data comprises MR-datasets for the target voxel and the auxiliary voxels for multiple Q-space shells or, in other words, for multiple non-zero b-values. Such implementations may lead to more accurate results of the interpolation.

In particular, such implementations may be used to obtain the interpolated MR-dataset for the target Q-space point, which is located on one of the Q-space shells, and for one or more further target Q-space points, which are located on the respective further Q-space shells, at once. This further reduces the overall computational time.

According to several implementations, a respective further interpolated MR-dataset for the target voxel is computed by means of the artificial neural network depending on the input data for each of the one or more further target Q-space points.

In particular, by applying the artificial neural network to the input data exactly once, the interpolated MR-dataset for the target Q-space point and the respective further interpolated MR-datasets for each of the one or more further target Q-space points are computed.

Such implementations may reduce the overall computational time compared to an approach interpolating the individual Q-space shells one after another. Furthermore, also the accuracy of the interpolated MR-dataset and the further interpolated MR-datasets may be improved due to the increased amount of Q-space points that can be considered by the artificial neural network.

According to several implementations, the artificial neural network comprises exactly H hidden layers, wherein H is non-zero and is equal to or less than four, preferably H is equal to or less than three, for example H is equal to or less than two.

In particular, in addition to the hidden layers, the artificial neural network comprises an input layer and an output layer. For example, a corresponding activation function, for example a ReLU-activation function, may be used for each of the hidden layers and the output layer.

By limiting the number of H hidden layers to four or less hidden layers, preferably to two hidden layers, the complexity of the artificial neural network, the effort for training the neural network as well as the runtime and memory requirements for the artificial neural network are significantly reduced, which contributes to a further speed up of the method.

Preferably, at least one of the H hidden layers, for example all of the H hidden layers, are designed as fully connected layers. By combining the relatively low number of H hidden layers with the full connection of one or more or all of the hidden layers, a very accurate but still small or in other words relatively shallow, neural network is realized.

According to several implementations, the DWI-data contains, for each of the plurality of Q-space points, respective MR-datasets for a further target voxel and for a plurality of further auxiliary voxels in a predefined further neighborhood of the further target voxel. The artificial neural network is applied to further input data, which contains the respective MR-dataset of the further target voxel and the plurality of further auxiliary voxels or consists of those respective MR-datasets for all of the plurality of Q-space points. A further interpolated MR-dataset for the further target voxel and for the target Q-space point is computed by means of the artificial neural network depending on the further input data.

In other words, the steps previously described with respect to the target voxel are also carried out for the further target voxel. In the same manner, in further implementations, the method may repeat the analog steps for all voxels as target voxels, for which a corresponding interpolated MR-dataset is desired or required by the respective application.

The further target voxel differs from the target voxel. However, depending on the distance of the further target voxel from the target voxel and the definition of the neighborhood and the further neighborhood, respectively, the neighborhood and the further neighborhood may partially overlap. In particular, the further neighborhood may comprise a fraction of the auxiliary voxels in the neighborhood of the target voxel or the neighborhood of the target voxel may comprise a fraction of the further auxiliary voxels in the further neighborhood of the further target voxel. In fact, in some cases, the target voxel may be one of the further auxiliary voxels and/or the further target voxel may be one of the auxiliary voxels.

According to a further aspect of the invention, a computer-implemented training method for training a trained artificial neural network for augmenting DWI-data is provided. Therein, training data is provided, wherein the training data comprises, for each of a plurality of Q-space points, respective MR-training-datasets for a target voxel and for a plurality of auxiliary voxels in a predefined neighborhood of the target voxel. Ground truth data for the target voxel and for a target Q-space point, which is not contained in the plurality of Q-space points, is provided. The artificial neural network, in particular the untrained or partially trained artificial neural network, is applied to the training data. An interpolated MR-dataset for the target voxel and for the target Q-space point is computed by means of the artificial neural network depending on the training data. A loss function is evaluated depending on the interpolated MR-dataset and the ground truth data. Parameters of the artificial neural net-

work, in particular network parameters of the artificial neural network, such as weighting factors and/or bias factors, are modified depending on a result of the evaluation of the loss function in order to train the artificial neural network.

Unless stated otherwise, all steps of the computer-implemented training method may be performed by at least one computing unit, for example of the magnetic resonance imaging system. In particular, the data processing apparatus comprises at least one processing circuit, which is configured or adapted to perform a computer-implemented training method according to the invention may perform the steps of the computer-implemented training method. For this purpose, the data processing apparatus may in particular store a computer program comprising instructions which, when executed by the data processing device, in particular the at least one processing circuit, cause the data processing apparatus to execute the computer-implemented training method.

The steps of the training method may be repeated with different training data until a predefined determination criterion is fulfilled, which indicates that the artificial neural network has been trained sufficiently according to predefined requirements.

The loss function may for example be a mean-square-error loss function. However, also different choices are possible.

According to at least one implementation of the computer-implemented training method, one of the plurality of Q-space points corresponds to a Q-space center and/or all Q-space points of the plurality Q-space points, which are not located in the Q-space center, are arranged on a single Q-space shell.

It has been found that the training is particularly efficient if the Q-space points are restricted to a single Q-space shell or in other words to a constant b-value apart from the optional Q-space center.

However, it is noted that, in other implementations, also multi-shell approaches may be followed, as explained above with respect to the respective implementations of the computer-implemented method for augmenting DWI-data according to the invention.

According to several implementations of the computer-implemented method for augmenting DWI-data according to the invention, the trained artificial neural network is trained by means of a computer-implemented training method according to the invention.

According to a further aspect of the invention, a method for DWI-imaging is provided. Therein, DWI-data is generated by acquiring, for each of a plurality of Q-space points, respective MR-datasets, for a target voxel and for a plurality of auxiliary voxels in a predefined neighborhood of the target voxel, by means of an MR-imaging system. A computer-implemented method for augmenting the DWI-data is carried out, in particular by at least one computing unit of the MR-imaging system, according to the invention.

According to a further aspect of the invention, a data processing apparatus comprising at least one processor is provided. The at least one processor is adapted to perform a computer-implemented method for augmenting DWI-data according to the invention and/or to perform a computer-implemented training method according to the invention.

According to a further aspect of the invention, a MR-imaging system for DWI is provided. The MR-imaging system comprises a MR-scanner, which is configured to generate DWI-data by acquiring, for each of a plurality of Q-space points, respective MR-datasets for a target voxel and for a plurality of auxiliary voxels in a predefined neighborhood of the target voxel. The MR-imaging system comprises at least one computing unit, which is in particular designed as a data processing apparatus according to the invention. The at least one computing unit is configured to apply a trained artificial neural network, which is for example stored on a storage device of the at least one computing unit, to input data, which contains the respective MR-datasets of the target voxel and the plurality of auxiliary voxels for all of the plurality of Q-space points. The at least one computing unit is configured to compute an interpolated MR-dataset for the target voxel and for a target Q-space point, which is not contained in the plurality of Q-space points, by means of the artificial neural network depending on the input data, in particular by applying the artificial neural network to the input data.

The MR-scanner and the at least one computing unit may or may not be strictly separated from each other. In particular, the MR-scanner may comprise the at least one computing unit completely or partly. For example, the MR-scanner may comprise a control unit, wherein the control unit is a part of the at least one computing unit.

For acquiring the DWI-data, the MR-scanner is controlled, for example by the control unit, to carry out a conventional acquisition scheme for DWI.

The MR-scanner may, for example, comprise a field magnet for generating a homogeneous ground field, one or more gradient coils for generating magnetic field gradients, in particular the diffusion gradient lobes, one or more RF-transmission antennas for generating respective RF-excitation pulses or RF-refocusing pulses and/or one or more receiving antennas for detecting respective MR-signals in response to the excitation.

The MR-scanner may also comprise the control unit, which is configured to control said individual components and to supply power and/or RF-signals to carry out the MR-imaging.

Further implementations of the MR-imaging system according to the invention following directly from the various implementations of the method for DWI-imaging according to the invention and the computer-implemented method for augmenting DWI-data and vice versa, respectively. In particular, an MR-imaging system according to the invention may be configured to carry out a method for DWI-imaging according to the invention or a computer-implemented method for augmenting DWI-data according to the invention or carries out such a method or computer-implemented method.

According to a further aspect of the invention, a first computer program comprising first instructions is provided. When the first instructions are executed by a data processing apparatus, in particular a data processing apparatus according to the invention, the first instructions cause the data processing apparatus, in particular the at least one processor, to perform a computer-implemented method for augmenting DWI-data according to the invention and/or to perform a computer-implemented training method according to the invention.

According to a further aspect of the invention, a second computer program comprising second instructions is provided. When the second instructions are executed by a MR-imaging system according to the invention, in particular by the at least one computing unit of the MR-imaging system, the second instructions cause the MR-imaging system to carry out a method for DWI according to the invention.

According to a further aspect of the invention, a computer-readable storage medium storing the first computer program and/or the second computer program according to the invention is provided.

The first computer program, the second computer program as well as the computer-readable storage medium may be considered as respective computer program products comprising the first and/or the second instructions, respectively.

If it is mentioned in the present disclosure that a component of the MR-imaging system according to the invention, in particular the at least one computing unit of the MR-imaging system, or a component of the data processing apparatus according to the invention, in particular the at least one processor of the data processing apparatus, is adapted, configured or designed to, et cetera, to perform or realize a certain function, to achieve a certain effect or to serve a certain purpose, this can be understood such that the component, beyond being usable or suitable for this function, effect or purpose in principle or theoretically, is concretely and actually capable of executing or realizing the function, achieving the effect or serving the purpose by a corresponding adaptation, programming, physical design and so on.

A computing unit may in particular be understood as a data processing device, which comprises processing circuitry. The computing unit may therefore in particular process data to perform computing operations. This may also include operations to perform indexed accesses to a data structure, for example a lookup table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable read-only memory, EPROM, an electrically erasable read-only memory, EEPROM, a flash memory or flash EEPROM, a ferroelectric random access memory, FRAM, a magnetoresistive random access memory, MRAM, or a phase-change random access memory, PCRAM.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1 shows schematically an exemplary implementation of an MR-imaging system according to the invention;

FIG 2 shows schematically the principle of an exemplary DWI-acquisition;

FIG 3 shows schematically a plurality of Q-space points and target Q-space points;

FIG 4 shows schematically an architecture of an artificial neural network for use in an exemplary implementation of a computer-implemented method for augmenting DWI-data according to the invention; and

FIG 5 shows schematically an MR-image containing interpolated MR-datasets obtained by a further exemplary implementation of a computer-implemented method for augmenting DWI-data according to the invention

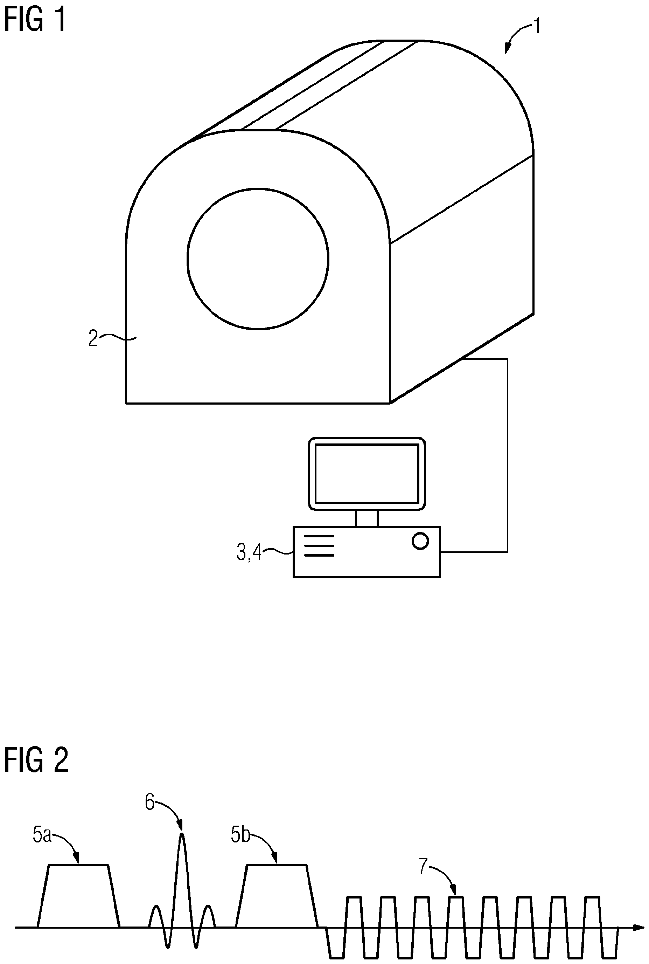

FIG 1 shows schematically an exemplary implementation of an MR-imaging system 1 according to the invention.

The MR-imaging system 1 comprises an MR-scanner 2 and a control unit 3 for controlling the MR-scanner 2. Furthermore, the MR-imaging system 1 comprises a computing unit 4 coupled to the control unit 3 and/or to the MR-scanner 2. Alternatively, the computing unit 4 may comprise the control unit 3 or vice versa. The MR-imaging system 1 may also comprise a storage unit (not shown) storing a computer program according to the invention.

The MR-imaging system 1 may be used to carry out a method for diffusion-weighted imaging, DWI, according to the invention. In particular, the computing unit 4 may execute the computer program according to the invention to cause the MR-imaging system 1 to carry out the method. Therein, the computing unit 4 may carry out an exemplary implementation of a computer-implemented method for augmenting DWI-data according to the invention.

In general, DWI may be considered to exploit the attenuation of the respective MR-signal, based on the diffusion of water molecules in the region to be imaged. The more diffusion occurs, the further a water molecule may move within a given period of time, which results in a reduction of the MR-signal. For example, cerebrospinal fluid, CSF, comprises water, which may diffuse rather easily so that the respective image regions may appear dark or black. On the other hand, water within tissues may not move as easily. Thus, a respective contrast may be achieved.

For diffusion-weighted imaging, one or more b0-images may be obtained. These are MR-datasets acquired without applying diffusion-weighting or, in other words, with b = 0, wherein

$$b = \gamma^2{}^\star G^2{}^\star\delta^2{}^\star(\Delta - \delta/3).$$

Therein, $\gamma$ denotes the gyromagnetic ratio, G denotes the amplitude of the diffusion gradient lobes, $\delta$ denotes their respective duration and $\Delta$ denotes the duration between them.

Furthermore, one or more images with b > 0, for example with b in the interval [100 s/mm$^2$, 10000 s/mm$^2$] or in the interval [200 s/mm$^2$, 5000 s/mm$^2$], are obtained. In particular, these may be obtained for different spatial directions of the diffusion gradients. Each spatial direction in combination with the used b-value defines a point in a three-dimensional space denoted as Q-space.

FIG 2 shows schematically the principle of an exemplary DWI-acquisition, during which for example an RF-refocusing pulse 6 is applied and a corresponding MR-signal 7 is obtained. Prior to and after the refocusing pulse 6 a respective diffusion gradient lobe 5a, 5b is applied according to a certain b-value. Furthermore, an RF-excitation pulse (not shown) is applied at the very beginning of the scheme, in particular prior to the diffusion gradient lobe 5a.

It is noted that the scheme of FIG 2 represents a non-limiting and not necessarily complete example for a particular DWI variant. The invention is not restricted to a particular variant of DWI. For example, it may be applied to monopolar or bipolar DWI-schemes, et cetera.

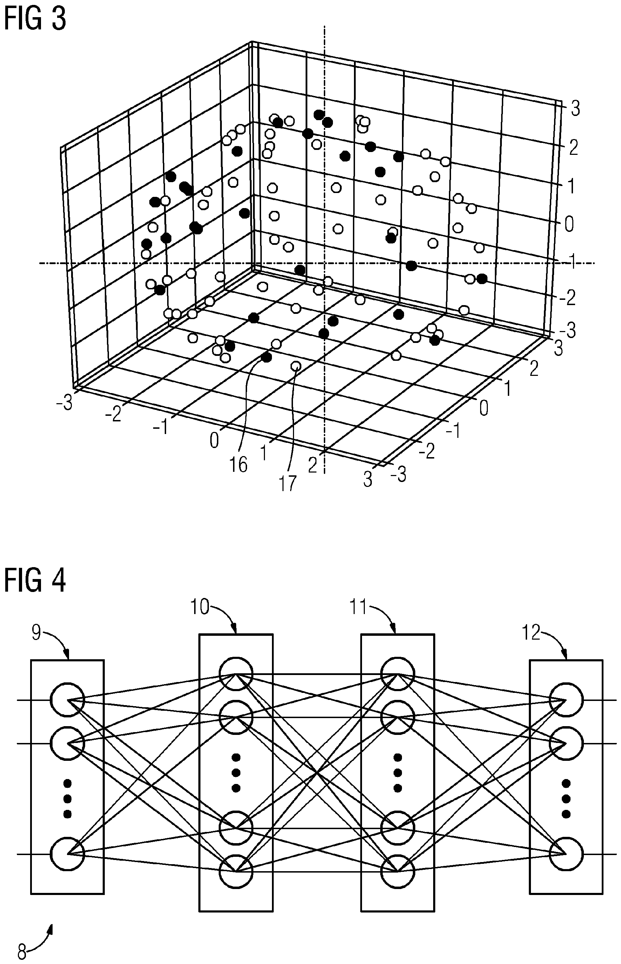

FIG 3 shows schematically a plurality of Q-space points 16 as filled circles, for which MR-data are obtained. Furthermore, FIG 3 shows a plurality of target Q-space points 17, for which no MR-data have been acquired.

The available images or MR-datasets, respectively may be combined to generate specific maps according to the actual application. In general, it is desirable for many applications to obtain MR-datasets for as many Q-space points as possible, at least within some limitations. However, this would require an inacceptable long time, in particular for clinical applications. Therefore, the invention aims to provide interpolated MR-datasets also for at least one of the target Q-space points 17.

To this end, the computing unit 4 may apply a trained artificial neural network, ANN, 8 (see FIG 4 for an exemplary architecture), on a voxel-by-voxel basis to the available MR-data. This means, for a certain target voxel, for which respective MR-datasets have been acquired for the plurality of Q-space points 16 but not for a specific target Q-space point 17, an interpolated MR-dataset is computed by means of the ANN 8 based on the MR-datasets, which are available for the target voxel and for each of a plurality of auxiliary voxels in a predefined spatial neighborhood of the target voxel, for example the 26 voxels surrounding the target voxel in three dimensions, for the plurality of Q-space points 16.

In other words, the ANN 8 is applied to input data, which contains the respective MR-datasets of the target voxel and the plurality of auxiliary voxels for all of the plurality of Q-space points 16 and the interpolated MR-dataset for the target voxel and for the target Q-space point 17 is computed as a result or depending on an output of the ANN 8. This may then be repeated for all target voxels of interest and all of the further target Q-space points 17 of interest.

By means of the ANN 8, a non-linear interpolating algorithm is implemented, which is particularly well-suited as it can capture a more accurate diffusion model than other algorithms, such as linear interpolation algorithms. Due to the voxel-by-voxel approach of the invention, an inherent diffusion model may be extracted from the respective training data without introducing significant fitting bias and with only a relatively small set of training data due to the potentially low complexity of the ANN 8. Moreover, additional anatomic data is not required as an input for the ANN 8.

FIG 4 shows schematically the architecture of an example for the ANN 8 designed for estimating diffusion weighted MR-dataset from other diffusion weighted MR-datasets for a given target voxel.

The ANN 8 of FIG 4 comprises 4 layers, namely an input layer 9, an output layer 12 and two hidden layers 10, 11, in particular fully connected hidden layers 10, 11. Each of the hidden layers 10, 11 may for example comprise 256 neurons. In this way, a voxel-by-voxel processing taking into account $3 \times 3 \times 3 = 27$ voxels including the target voxel and its 26 surrounding voxels is realized. For each of the hidden layers 10, 11 and the output layer 12, an activation function, for example a ReLU activation function, may be used.

The training of the ANN 8 may for example be carried out separately for each of a plurality of b-values or the artificial neural network may comprise a respectively trained sub-networks for each of the plurality of b-values. The mean-square-error, MSE, may be used as a loss function.

In an example, the ANN 8 of FIG 4 may synthesize each of $N_{out}$ target voxels on a per-voxel basis from $N_{in}$ acquired DWI-directions and b=0 s/mm² voxels. The acceleration factor R for a given shell acquisition is therefore $R = N_{in} / (N_{in} + N_{out})$.

The input layer 9 takes for example $N_{in}$ blocks of size 3x3x3 centered around the target voxel location, followed by the two densely connected hidden layers 10, 11 of 256 neurons each, and the output layer 12 produces the $N_{out}$ voxels. Each layer may use a ReLU activation function.

Training and validation datasets may be gathered for example from 20 and 40 subjects, respectively, of the Human Connectome Project, HCP, database, treated as voxels with dimension $145 \times 174 \times 145$ at a 1.25mm isotropic resolution, with 90 DWI-directions at b = 1000 s/mm² and b=3000 s/mm², and a single b=0 image. Brain-masks provided by the HCP database may be used to exclude non-brain-tissue voxels from training and validation.

The network may be trained for each b-value with $N_{in} = 31$ and $N_{out} = 60$, meaning that the acceleration factor is approximately 3.

The input DWI-directions may for example be chosen to best match a 3D golden angle sampling scheme. Training using a mean-square-error loss-function may be carried out for example over 100 training epochs.

The ANN 8 is, in particular, small but highly non-linear and enables the use of information from the spatial neighborhood of the target voxels. It is able to capture an inherent diffusion model better than a linear interpolation approach, particularly for higher b-values. Due to the small size, a fast, reproducible training without need for additional regularization is possible.

While the ANN 8 with only two hidden layers 9, 10 may already yield satisfying results, further improvement may be possible, for example by adding 3D-convolution layers, batch normalization and/or weight regularization. Other modifications regarding of the number, size and type of layers, including but not limited to fully connected layers, convolution layers, dropout layers, batch normalization layers or pooling layers, are possible as well and may further optimize the results.

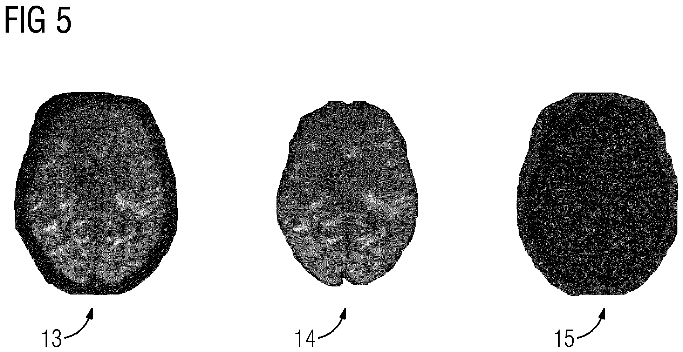

FIG 5 shows schematically the acquisition 13 of a diffusion weighted image at a b-value of 3000 s/mm$^2$ and a corresponding approximated interpolation reconstruction 14, for which only one third of the Q-space points used for the reconstruction 13 have been considered. Furthermore, an image 15 of the difference between the approximated reconstruction 14 and the reconstruction 13 is shown.

Several implementations of the invention aim at Q-space undersampling to speed up the overall image acquisition process and to infer the missing diffusion data by means of a relatively simple ANN. The ANN may be designed to reconstruct diffusion weighted images for diffusion directions or, in other words points in Q-space, which have been omitted during the original acquisition, from acquired diffusion data at other directions or points in Q-space, respectively, and optionally an acquisition at a b-value of zero. The network may consist of an input layer, several hidden layers and an output layer and/or may act on a voxel-by-voxel basis, that is it may reconstruct diffusion weighed data at a specific voxel from other diffusion weighted data at the same voxel, and may take into account data at neighboring voxels around the target voxel. The ANN can be used even with a relatively small number of training subjects.

Implementations of the invention may provide additional means to accelerate diffusion weighted MR-acquisitions. The invention can be used in addition to established acceleration methods that are currently used in clinical practice, such as parallel imaging, compressed sensing, simultaneous multi-slice imaging and/or other techniques that utilize undersampling of the k-space and/or acquire multiple slices at the same time. For an artefact-free image reconstruction, the missing information may be inferred from multiple receiver coils and/or prior knowledge during the image reconstruction process.

Consequently, the invention allows for shortening the overall scan time. The reduced scan time may for example be exploited to

- reduce the overall patient examination time,
- reduce the likelihood of motion artefacts in diffusion scans,
- improve spatial resolution of diffusion scans,
- improve the Q-space resolution of diffusion scans, and/or

- reduce diffusion examination scan times to levels, which are acceptable to a wider range of applications in clinical practice, increasing the applicability of diffusion examinations to a wider patient population.

Compared to compressed sensing acceleration methods, the invention may facilitate shorter reconstruction times at reduced computational requirements and without the need to introduce heuristic priors.

In view of other machine learning approaches, advantages of several implementations of the invention may include the usage of a particularly small ANN, a high level of nonlinearity to capture the inherent diffusion model, which is superior to linear interpolation. Furthermore, a fast and reproducible training without additional regularization may be used. Also, no additional anatomical and/or morphological MR-imaging data are required.

In some implementations, the invention makes use of an efficient, densely connected artificial neural network to synthesize skipped or unacquired DWI-directions from other acquired DWI-directions and, for example, acquisitions at b = 0.

In a test case, for training the artificial neural network, a high-quality dataset of 20 subjects of the Human Connectome Project, HCP, has been used with 90 DWI-directions per subject at both b=1000 mm$^2$/s and 3000 mm$^2$/s. 40 HCP subjects were used for validation. 30 DWI-directions for non-zero b-value and in addition b = 0 were selected for input to reconstruct the other 60 missing target DWI-directions. A comparison with a linear-interpolation benchmark showed an improved fidelity of the synthesized DWI-directions FOD maps to a gold standard acquisition, for both of said b-values.

**Claims**

1. Computer-implemented method for augmenting diffusion-weighted magnetic resonance imaging, DWI-, data, wherein the DWI-data contains, for each of a plurality of Q-space points (16), respective magnetic resonance, MR-, datasets for a target voxel and for a plurality of auxiliary voxels in a predefined neighborhood of the target voxel,
**characterized in that**

   - a trained artificial neural network (8) is applied to input data, which contains the respective MR-datasets of the target voxel and the plurality of auxiliary voxels for all of the plurality of Q-space points (16); and
   - an interpolated MR-dataset for the target voxel and for a target Q-space point (17), which is not contained in the plurality of Q-space points (16), is computed by means of the artificial neural network (8) depending on the input data.

2. Computer-implemented method according to claim 1, wherein the auxiliary voxels in combination with the target voxel form a cube, in particular a cube with a side length of three voxels, wherein the target voxel is located in the center of the cube.

3. Computer-implemented method according to one of the preceding claims, wherein one of the plurality of Q-space points (16) corresponds to a Q-space center.

4. Computer-implemented method according to one of the preceding claims, wherein all Q-space points (16) of the plurality of Q-space points (16), which are not located in the Q-space center, are arranged on a single spherical Q-space shell.

5. Computer-implemented method according to claim 4, wherein the target Q-space point (17) is located on the Q-space shell.

6. Computer-implemented method according to one of claims 1 to 3, wherein the plurality of Q-space points (16) comprises at least two subsets of Q-space points, wherein for each subset of Q-space points, all Q-space points of the respective subset are arranged on a respective single Q-space shell.

7. Computer-implemented method according to one of the preceding claims, wherein
the artificial neural network (8) comprises exactly H hidden layers (10, 11), wherein H is equal to or less than four, preferably H is equal to or less than three, for example H is equal to or less than two.

8. Computer-implemented method according to one of the preceding claims, wherein the DWI-data contains, for each of the plurality of Q-space points (16), respective MR-datasets for a further target voxel and for a plurality of further auxiliary voxels in a predefined further neighborhood of the further target voxel;

   - the artificial neural network (8) is applied to further input data, which contains the respective MR-datasets of the further target voxel and the plurality of further auxiliary voxels for all of the plurality of Q-space points (16); and
   - a further interpolated MR-dataset for the further target voxel and for the target Q-space point (17) is computed by means of the artificial neural network (8) depending on the further input data.

9. Computer-implemented training method for training an artificial neural network (8) for augmenting diffusion-weighted magnetic resonance imaging, DWI-, data, wherein

   - training data is provided, wherein the training data contains, for each of a plurality of Q-space points (16), respective magnetic resonance, MR-, training datasets for a target voxel and for a plurality of auxiliary voxels in a predefined neighborhood of the target voxel;
   - ground trough data for the target voxel and for a target Q-space point (17), which is not contained in the plurality of Q-space points (16), is provided;
   - the artificial neural network (8) is applied to the training data;
   - an interpolated MR-dataset for the target voxel and for the target Q-space point (17) is computed by means of the artificial neural network (8) depending on the training data;
   - a loss function is evaluated depending on the interpolated MR-dataset and the ground trough data;
   - network parameters of the artificial neural network (8) are modified depending on a result of the evaluation of the loss function.

10. Computer-implemented training method according to claim 9, wherein

   - one of the plurality of Q-space points (16) corresponds to a Q-space center and/or all Q-space points (16) of the plurality of Q-space points (16), which are not located in the Q-space center, are arranged on a single spherical Q-space shell; or
   - the plurality of Q-space points (16) comprises at least two subsets of Q-space points, wherein for each subset of Q-space points, all Q-space points of the respective subset are arranged on a respective single Q-space shell.

11. Computer-implemented method according to one of claims 1 to 8, wherein the artificial neural network (8) is trained by means of a computer-implemented training method according to one of claims 9 or 10.

12. Method for diffusion-weighted magnetic resonance imaging, DWI, wherein

   - DWI-data is generated by acquiring, for each of a plurality of Q-space points (16), respective MR-datasets, for a target voxel and for a plurality of auxiliary voxels in a predefined neighborhood of the target voxel, by means of an MR-imaging system (1); and
   - a computer-implemented method for augmenting the DWI-data is carried out according to one of claims 1 to 8 or according to claim 11.

13. Data processing apparatus comprising at least one processor adapted to perform a computer-implemented method according to one of claims 1 to 8 or according to claim 11 and/or to perform a computer-implemented training method according to one of claims 9 or 10.

14. Magnetic resonance imaging system (1) for diffusion-weighted magnetic resonance imaging, DWI, the MR-imaging system (1) comprising an MR-scanner (2), which is configured to generate DWI-data by acquiring, for each of a plurality of Q-space points (16), respective MR-datasets for a target voxel and for a plurality of auxiliary voxels in a predefined neighborhood of the target voxel,
**characterized in that**
the MR-imaging system (1) comprises at least one computing unit (3, 4), which is configured to

   - apply a trained artificial neural network (8) to input data, which contains the respective MR-datasets of the target voxel and the plurality of auxiliary voxels for all of the plurality of Q-space points (16); and
   - compute an interpolated MR-dataset for the target voxel and for a target Q-space point (17), which is not contained in the plurality of Q-space points (16), by means of the artificial neural network (8) depending on the input data.

15. Computer program product comprising

   - instructions, which, when executed by a data processing apparatus according to claim 13, cause the data processing apparatus to perform a computer-implemented method according to one of claims 1 to 8 or according to claim 11 and/or to perform a computer-implemented training method according to one of claims 9 or 10; or
   - instructions, which, when executed by a MR-imaging system (1) according to claim 14, cause the MR-imaging system (1) to carry out a method according to claim to 12.

FIG 1

FIG 2

## FIG 3

## FIG 4

FIG 5

## EP 4 246 169 A1

Europäisches Patentamt

European Patent Office

Office européen des brevets

# EUROPEAN SEARCH REPORT

**Application Number**

EP 22 16 1898

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JHA RANJEET RANJAN ET AL: "Single-shell to multi-shell dMRI transformation using spatial and volumetric multilevel hierarchical reconstruction framework", MAGNETIC RESONANCE IMAGING, ELSEVIER SCIENCE, TARRYTOWN, NY, US, vol. 87, 10 January 2022 (2022-01-10), pages 133-156, XP086948539, ISSN: 0730-725X, DOI: 10.1016/J.MRI.2021.12.011 [retrieved on 2022-01-10] | 1,2,4, 6-15 | INV. G01R33/56 G01R33/563 |
| A | * page 133 - page 143; figures 2-7 * | 3,5 | |
| X | HE PEIDONG ET AL: "Towards individual direction-based deep learning of diffusion weighted images for standard diffusion model analysis", PROCEEDINGS OF THE INTERNATIONAL SOCIETY FOR MAGNETIC RESONANCE IN MEDICINE, 28TH ANNUAL MEETING AND EXHIBITION, 8-14 AUGUST 2020, vol. 28, 4358, 24 July 2020 (2020-07-24), XP040718273, | 1,2,4,5, 7-15 | |
| A | * page 1; figures 1, 2 * | 3,6 | TECHNICAL FIELDS SEARCHED (IPC) G01R |
| X | YOONMI HONG ET AL: "Multifold Acceleration of Diffusion MRI via Slice-Interleaved Diffusion Encoding (SIDE)", ARXIV.ORG, CORNELL UNIVERSITY LIBRARY, 201 OLIN LIBRARY CORNELL UNIVERSITY ITHACA, NY 14853, 25 February 2020 (2020-02-25), XP081607609, * page 2 - page 9; figures 1-3 * | 1,3,6, 8-15 | |

The present search report has been drawn up for all claims

| Place of search | Date of completion of the search | Examiner |
|---|---|---|
| Munich | 12 August 2022 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Q.TIAN et al.** DeepDTI: High-fidelity six-direction diffusion tensor imaging using deep learning. *Neuroimage,* 2020, vol. 219, 117017